# EUROPEAN PATENT APPLICATION

(11) **EP 2 060 608 A1**
(43) Date of publication of application: **20.05.2009**
(21) Application number: 07120738.5
(22) Date of filing: 15.11.2007
(51) Int. Cl.: C09B 67/04, G03F 7/00, C09B 67/12, C09B 67/22, C09B 67/50

(54) **Preparation of epsilon copper phthalocyanine of small primary particle size and narrow particle size distribution by kneading**

(71) Applicant: SOLVAY (Société Anonyme), 1050 Bruxelles (BE)
(72) Inventor: Jung, KiSuck, Pusan (KR); Han, Sang-Min, Pusan (KR); Jeong, Hyun-Seok, Pusan (KR); Choi, Il-Jo, Pusan (KR); Kim, Dong-Yoon, Ulsan (KR); Jeong, Eun-Ha, Ulsan (KR)
(74) Representative: Vande Gucht, Anne

(57) **Abstract**

A process of preparing copper phthalocyanine particles exhibiting a ε crystallographic form, comprising a kneading step by kneading at at least two different temperatures copper phthalocyanine particles wherein more than 80 wt % of the particles exhibit an a crystallographic form in presence of a liquid and of at least one inorganic salt.

## Description

### Technical field

The present invention relates to a process of preparing epsilon crystal form copper phthalocyanine (ε-CuPc) particles of small particle size and narrow particle size distribution, epsilon crystal form copper phthalocyanine particles obtainable according to said process and the use of the same for the preparation of blue filters pigments for the fabrication of liquid crystal display (LCD) devices.

### Background art

Among all pigments, copper phthalocyanine is especially stable and is excellent in terms of a variety of fastness. Further, the copper phthalocyanine has many crystal forms. Of these crystal forms, those known to have already found their actual use include alpha, beta and epsilon crystal forms of copper phthalocyanine. It is a common practice to use the beta crystal form to impart a greenish blue colour and the alpha crystal form to impart a reddish blue colour. However, the epsilon crystal form is employed when the impartation of a blue colour, which is more reddish than that available from the use of the alpha crystal form, is required (Kirk Othmer, Encyclopedia of Chemical Technology, Third Edition, Volume 17, 1982, pp.777-787).

The epsilon crystal form copper phthalocyanine has a reddish hue, a high clearness and a high tinting strength compared to the alpha crystal form. In addition, their solvent resistance against the crystal growth of primary crystals is higher than that of the beta crystal form. Further, their solvent resistance against the crystal transformation into the beta crystal form is higher than that of other polymorph copper phthalocyanines. Therefore, the epsilon crystal form copper phthalocyanine is a molecular aggregate having a crystal form, which has remarkably excellent properties with less apprehension about a change of hue and a decrease in tinting strength and clearness. Also, the thermodynamic stability of the epsilon crystal form is next to that of the beta crystal form, which is the most stable crystal form among polymorph crystals.

It has repeatedly been disclosed that copper phthalocyanine (crystallographically crude or in the pure alpha crystallographic phase) is easily convertible into its beta crystal form, e.g., by salt grinding with a solvent, dry grinding in the presence or absence of a salt followed by solvent treatment, dry grinding with a solid binder in an inert atmosphere, or dry or aqueous grinding followed by conditioning.

Further, the typical process for the production of epsilon crystal form copper phthalocyanine is the solvent salt milling process. In such a process, copper phthalocyanine particles having a crystal other than the epsilon crystal form and copper phthalocyanine particles having epsilon crystal form are milled in an organic solvent in the presence of beads by means of a strong mechanical force for a long time.

KR 100215919B describes a method of manufacturing epsilon crystal form copper phthalocyanine pigment using a novel copper phthalocyanine derivative. This process comprises adding 5-30 wt% of the copper phthalocyanine derivative with reference to alpha, gamma crystal form copper phthalocyanine or mixture thereof and mechanically kneading the mixture at 50-180°C to restrict crystal conversion into beta copper phthalocyanine and derive stable crystal transition into epsilon crystal form copper phthalocyanine.

JP2000258620 discloses a process for manufacture of ε-CuPc fine pigment which involves milling crude ε-CuPc, semi-crude ε-CuPc, in the presence of organic solvent and mineral salt. It also discloses manufacture of epsilon-type copper-phthalocyanine fine pigment which involves milling epsilon-type copper-phthalocyanine crude, semi-crude epsilon-type copper-phthalocyanine containing alpha-type copper-phthalocyanine or epsilon-type copper-phthalocyanine pigment having BET specific surface area of 95-150 m²/g or less in a nitrogen absorption process, using solvent and 8-20 weight parts of mineral salt per weight part of crude, semi-crude or pigment and removing an organic solvent and mineral salt.

EP 1130065 discloses a conversion of copper phthalocyanine into the epsilon crystal form. It also discloses a manufacture of pigment composition by wet and dry grinding of copper phthalocyanine, another polycyclic pigment and a copper phthalocyanine derivative.

JP 2002121420 discloses a process of manufacturing epsilon crystal form copper phthalocyanine fine pigment. This process involves milling crude epsilon crystal form copper phthalocyanine in the presence of an organic solvent and a mineral salt. Such manufactured epsilon crystal form copper phthalocyanine fine pigment has BET specific surface area of 95-150 m²/g in a nitrogen absorption process. Further, it exhibits excellent dispersibility and lightness.

JP2002189119, US2004237842 and EP1299479 disclose processes for conversion of CuPC into the ε form and manufacture of pigment composition by salt kneading of CuPc and another pigment. JP2007009007 further discloses the use of phthalide alkylated phthalocyanine and higher fatty acid in the conversion process.

JP 2004244563 describes a method of producing epsilon crystal form copper phthalocyanine pigment, wherein the pigment particles are micronized and sized comparable to the solvent salt milling method. In said method, crude epsilon crystal form copper phthalocyanine pigment with a greater average particle diameter than 100 nm is added to pre-pigment with an average particle diameter of 10-100 nm. The mixture is subjected to dry grinding by adding a small amount of an organic solvent. Particle size regulation is performed by suppressing a change of average particle diameter of the ε-CuPc pigment to 30 nm or less.

US 2005215780 describes a process for the production of epsilon crystal form copper phthalocyanine. Such a process comprises heat-treating copper phthalocyanine in a solvent at a temperature ranging from 80°C to 250°C in the presence of a Lewis acid.

However, the foregoing methods of preparing epsilon crystal form copper phthalocyanine of the prior art have problems in that they need too much time for crystal phase conversion and particle size reduction. It has thus been desired to develop a method of effectively preparing epsilon crystal form copper phthalocyanine with reduced time for crystal phase conversion and particle size reduction.

### Disclosure of the invention

It is thus a first object of the invention to provide a process of preparing epsilon crystal form copper phthalocyanine, which needs shorter time to obtain the epsilon crystal form copper phthalocyanine with a high crystallographic purity.

Another object of the invention is to provide epsilon crystal form copper phthalocyanine primary particles of small size and narrow particle size distribution obtainable according to said process.

Still yet another object of the invention is to use said epsilon crystal form copper phthalocyanine particles in the preparation of color filter pigments and in the fabrication of liquid crystal display (LCD) devices.

Hereinafter, the present invention is described in detail.

It is the purpose of the present invention to develop copper phthalocyanine (CuPc), which can be effectively used as blue pigment of color filters for LCD. Such filters (e.g., phthalocyanine) must be highly transparent, homogeneous and able to be prepared in a layer with a very uniform thickness. These features are decided by chemical purity, crystallographic purity, primary particle size and particle size distribution of copper phthalocyanine. In this regard, the present invention is directed to developing a new and more efficient process of preparing copper phthalocyanine, which satisfies the above-mentioned features.

The invention is therefore related to a process of preparing copper phthalocyanine particles exhibiting a ε crystallographic form, comprising a kneading step by kneading at at least two different temperatures copper phthalocyanine particles wherein more than 80 wt % of the particles exhibit an α crystallographic form, in presence of at least one liquid and of at least one inorganic salt. Preferably more than 85 wt % of the particles exhibit an α crystallographic form, more preferably more than 90 wt % of the particles exhibit an α crystallographic form, most preferably more than 95 wt % of the particles exhibit an α crystallographic form.

In the process of the invention, generally less than 20 wt%, preferably less than 15 wt %, more preferably less than 10 wt %, most preferably less than 5 wt % of the particles used in the kneading step exhibit an ε crystallographic form. Such particles are generally used as seeds.

The process of the present invention is preferably characterized by the following two steps: 1) crystal phase conversion of copper phthalocyanine from beta crystal form to alpha crystal form; and 2) crystal phase conversion of copper phthalocyanine from alpha crystal form to epsilon crystal form as well as primary particle size reduction of the copper phthalocyanine particles by kneading.

The averaged primary particle size of copper phthalocyanine finally obtained by the process of the present invention is generally lower than or equal to 30 nm, preferably lower than or equal to 20 nm, which is smaller than those of commercially available products. Since epsilon crystal form copper phthalocyanine having a smaller particle size causes a better contrast of color filter, they can be effectively used as blue filters for LCD devices. The averaged primary particle size can be determined by selecting at least 50 primary particles in the transmission electron microscope (TEM) image which form aggregates and then obtaining an averaged value of their longitudinal diameters.

The copper phthalocyanine particles exhibiting an α crystallographic form used in the process of the invention can be prepared by any process. It is preferred that they are prepared from copper phthalocyanine particles exhibiting a (β crystallographic form by using an acid paste method. The beta crystal form copper phthalocyanine is commercially available from various companies such as Toyo Ink (Japan), Dainippon Ink & Chemicals Co. (Japan), etc. The beta crystal form copper phthalocyanine is subjected to crystal phase conversion into alpha crystal form by acid pasting. Acid pasting refers to the dissolution preferably complete of the pigment preferably crude in an acid followed by precipitation. Preference is given to using acids such as sulfuric acid, chlorosulfonic acid and polyphosphoric acid. The precipitation medium, which is employed, generally comprises water, organic solvents or mixtures thereof. Precipitation takes place preferably under turbulent flow conditions. Such a treatment is described for instance in Ullmann's Encyclopedia of Industrial Chemistry, Fifth Completely Revised Edition, 1992, Volume A20, pp. 225-226.

In step 2, the alpha crystal form copper phthalocyanine is subjected to kneading for crystal phase conversion and particle size reduction.

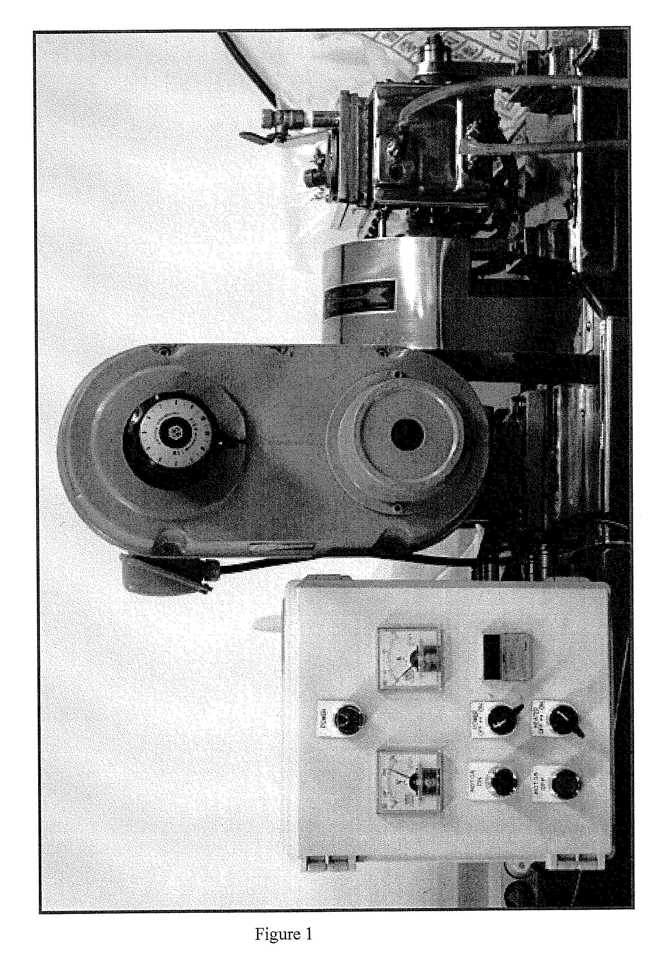

The step of kneading the same with salt is conducted in the presence of at least one liquid. To achieve the preferred salt kneading process, it is possible to use a typical continuous kneading unit well known in the art, including a single kneading-screw type and a twin kneading-screw type. In the preferred embodiment, the present invention employs a salt-kneading system, which is illustrated in Fig. 1.

The kneading step is carried out at at least two different temperatures in presence of at least one liquid and of at least one inorganic salt. The temperatures during the kneading step may be changed continuously under a constantly varying temperature profile, or at least one time (stepwise). Preferably, kneading is conducted at the first temperature and then at the second temperature. The first temperature is generally higher than or equal to 80 °C and preferably higher than or equal to 100 °C. The first temperature is generally lower than or equal to 150 °C and preferably lower than or equal to 130 °C. The second temperature is generally higher than or equal to 30 °C, and preferably higher than or equal to 45 °C. The second temperature is generally lower than or equal to 70 °C and preferably lower than or equal to 60 °C.

The kneading step is carried out for a duration which is generally higher than or equal to 2 h, preferably higher than or equal to 3 h, more preferably higher than or equal to 5 h and most preferably higher than or equal to 6 h. Such duration is generally lower than or equal to 36 h, preferably lower than or equal to 18 h, more preferably lower than or equal to 12 h and most preferably lower than or equal to 8 h.

The liquid suitable for the kneading step may include, but is not limited to, water, N-methyl-2-pyrrolidone, sulfolane, N,N-dimethyl formamide, diethylene glycol, N-methyl formamide, diacetone alcohol, glycerin, ethylene glycol, propylene glycol, polypropylene glycol, 2-butoxy ethanol, triethylene glycol, diethylene glycol monomethyl ether, triethylene glycol monomethyl ether, dipropylene glycol monomethyl ether, 1-methoxy-2-propanol,l-ethoxy-2-propanol, ketones, quinolines and any mixture of at least two of the above. Further, the liquid is preferably N-methyl-2-pyrrolidone. The liquid may further comprise as an additive at least one acid selected from inorganic and organic acids such hydrochloric acid, nitric acid, sulfuric acid, phosphoric acid, acetic acid, formic acid, etc.

In the kneading step, the proportion by weight ratio of the liquid to the copper phthalocyanine to be kneaded is generally higher than or equal to 0.033 and more preferably higher than or equal to 0.050. Such proportion is generally lower than or equal to 10, preferably lower than or equal to 5, still more preferably lower than or equal to 2, yet more preferably lower than or equal to 1 and most preferably lower than or equal to 0.666.

In the kneading step according to the present invention, the inorganic salt suitable for the salt kneading process may include, but is not limited to, aluminum sulfate, sodium sulfate, calcium chloride, potassium chloride or sodium chloride, or any mixture of at least two of them. The inorganic salt is preferably sodium chloride which may, if desired and available, contain water of crystallization. The proportion by weight ratio of salts to the copper phthalocyanine to be kneaded is generally higher than or equal to 0.067 and preferably higher than or equal to 0.1. Such proportion is generally lower than or equal to 40, preferably lower than or equal to 10, more preferably lower than or equal to 5, yet more preferably lower than or equal to 1.0 and most preferably lower than or equal to 0.2.

The inorganic salt has an average particle, which is generally higher than or equal to 0.3 µm. Such average particle size is generally lower than or equal to 200 µm, preferably lower than or equal to 50 µm, which was measured by using the Particle Size Analyzer. The inorganic salt is generally soluble in water, preferably to the extent of at least 10 g/100 ml of water.

The rotary speed of the salt kneading system used in the present invention should be adjusted, taking into account the cooling (if necessary), in such a way that the kneaded composition is moved homogeneously under a uniform share. It is preferable to maintain the rotary speed during the salt kneading to the range from 30 to 150 rpm, and more preferably from 50 to 120 rpm.

Through the kneading step described above, the alpha crystal form copper phthalocyanine can be effectively converted into the epsilon crystal form having a narrow particle size distribution, which was determined from D₁₀ and D₉₀ percentiles measured by the Particle Size Analyzer.

The process according to the invention may further comprise a recovery step (step 4) by recovering the copper phthalocyanine particles by removing the liquid and the inorganic salt.

The recovery step can be carried out by any means, for instance filtration using any appropriate filter, decantation, centrifugation, etc. Preferably, filtration can be used to separate the copper phthalocyanine particles exhibiting a ε crystallographic form. Another preferred means is by washing the inorganic salt and the liquid away with water, especially with demineralized water.

The process according to the invention may comprise a further drying step (step 4) after the recovery step. The drying step is conducted generally at a temperature higher than or equal to -20°C, preferably higher than 0 °C, more preferably higher than or equal to 20°C, still more preferably higher than or equal to 60 °C, and most preferably higher than or equal to 75 °C. This temperature is generally lower than or equal to lower than or equal to 250°C, preferably lower than or equal to 200°C, still more preferably lower than or equal to 150 °C, yet more preferably lower than or equal to 100 °C and most preferably lower than or equal to 85°C. The drying step is conducted generally at a pressure higher than or equal to 10⁻¹ Pa, preferably higher than or equal to 1 Pa, more preferably higher than or equal to 10⁻¹ Pa, still more preferably higher than or equal to 10², and most preferably higher than or equal to 9 10³ Pa. This pressure is generally lower than or equal to lower than or equal to 10⁵, preferably lower than or equal to 5 10⁴ Pa, still more preferably lower than or equal to 2 10⁴ Pa and most preferably lower than or equal to 1.1 10⁴ Pa.

In order to increase dispersability of the resultant copper phthalocyanine particles exhibiting a ε crystallographic form, particles of copper phthalocyanine substituted by a functional group (dispersion aid) may be further added during the acid pasting step and/or the kneading step of the process according to the invention.

In addition, the process of the present invention may further comprise a step of dry-blending (step 5), wherein particles of copper phthalocyanine substituted by a functional group are further blended with the phthalocyanine particles recovered after the recovery step.

The particles of copper phthalocyanine used as a dispersion aid in the present invention may be substituted by at least one functional group selected from -SO₃M, -SO₂NR₁R₂ and -R₃-NR₄R₅, wherein: R₁ and R₂ are independent of one another and are hydrogen, alkyl, alkenyl, aryl or cycloalkyl; M is proton, ammonium cation or metal cation; R₃ is single bond, alkylene, arylene, said alkylene and arylene may be substituted by at least one substituent; and R₄ and R₅ are independent of one another and are hydrogen, alkyl, alkenyl, aryl or cycloalkyl, or collectively form a condensed structure containing at least one of -CO-, -SO₂- and -N=N-.

More preferably, the particles of copper phthalocyanine may be substituted by the functional group of -SO₃H, -SO₂NHR, , wherein R₁ is hydrogen, alkyl, alkenyl, aryl, cycloalkyl or

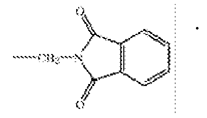

In a preferred embodiment, the process according to the invention comprises the following steps :
1) preparing copper phthalocyanine particles exhibiting an α crystallographic form from copper phthalocyanine particles exhibiting a (β crystallographic form by using an acid paste method
2) kneading at at least two different temperatures the copper phthalocyanine particles prepared in step 1) in the presence of at least one inorganic salt and at least one liquid; and optionally in the presence of copper phthalocyanine particles exhibiting an ε crystallographic form
3) recovering the copper phthalocyanine particles by removing the liquid and the inorganic salt
4) optionally drying the copper phthalocyanine particles recovered from step 3)
5) optionally dry-blending the copper phthalocyanine particles recovered from step 2) or 3) with a dispersion aid as defined above.

In spite of reducing the kneading time compared to the existing method in the art, the process of the present invention can obtain epsilon crystal form copper phthalocyanine having a smaller averaged primary particle size, a narrower size distribution and a better primary particle shape.

The average primary particle size is generally lower than or equal to 30 nm, preferably lower than or equal to 20 nm.

The particle size distribution (PSD) is measured by a Particle Size Analyzer (PSA). The narrowness of the particle size distribution is characterized from D₁₀ and D₉₀ values measured by the PSA.

The primary particle shape of the CuPc particles is preferably a spherical shape, when observed by their TEM image.

It is believed that one embodiment of the present invention provides modification of temperature condition during the kneading step by which CuPc particles exhibiting α-crystallographic form is converted to ε-crystallographic form easily and their particle size is significantly reduced, and further the process reduces the time for crystal phase conversion and particle size reduction.

The present invention is also directed to epsilon crystal form copper phthalocyanine particles obtainable according to the process of the present invention. The present invention is further directed to the use of the same in the preparation of color filter pigments.

Further, the present invention is directed to colour filter pigments comprising the epsilon crystal form copper phthalocyanine particles prepared according to the process of the present invention. Also, the present invention is directed to the use of the same in the fabrication of liquid crystal display devices.

### Brief description of drawings

Fig. 1 shows a salt-kneading system used in the process of the present invention.

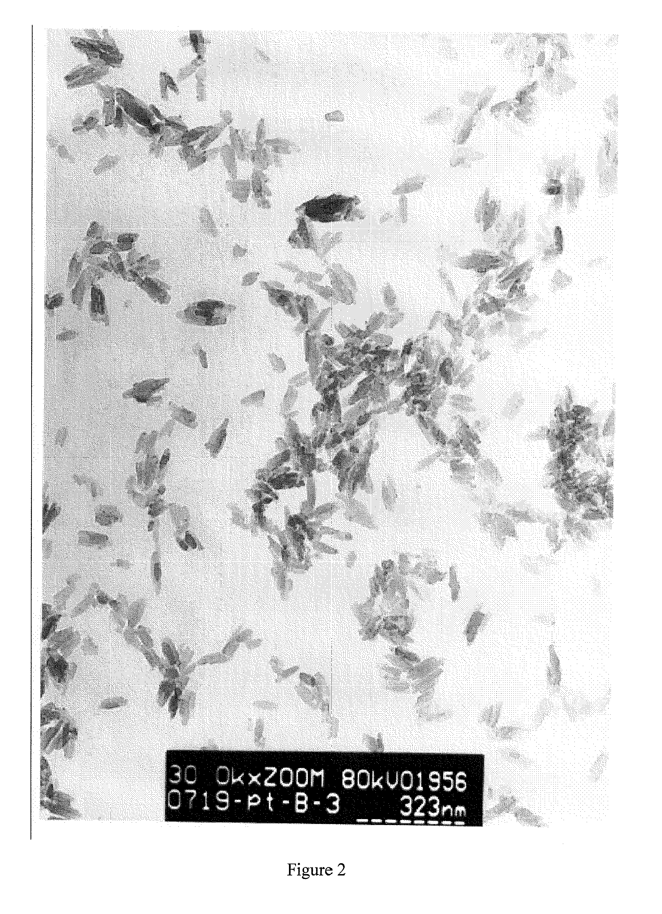

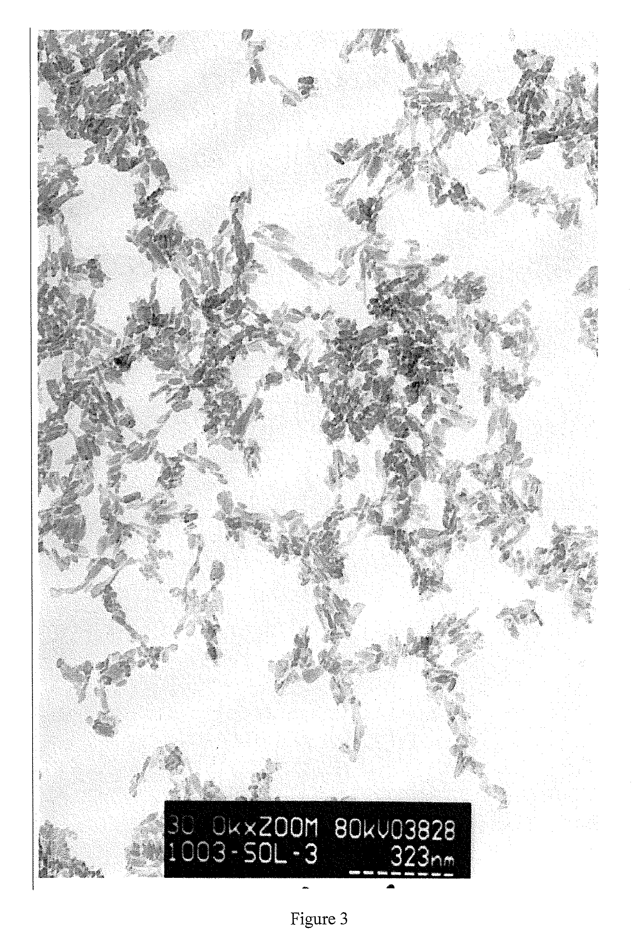

Figs. 2 and 3 show transmission electron micrographs of the epsilon crystal form copper phthalocyanine particles obtained before and after the salt-kneading, respectively, according to the process of the present invention.

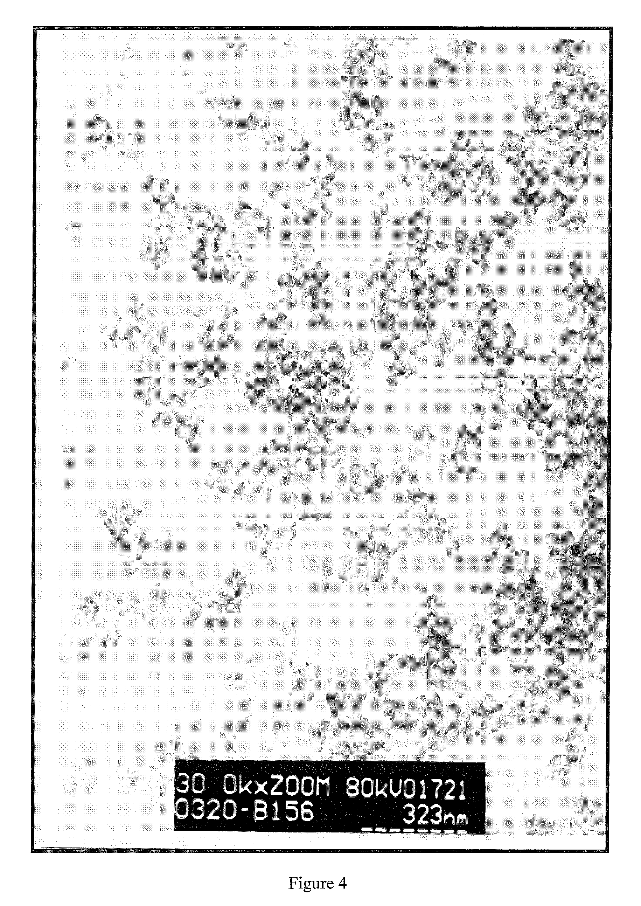

Fig. 4 shows a transmission electron micrograph of the epsilon crystal form copper phthalocyanine particles, which are commercially available (purchased from Dainippon Ink & Chemicals Co. located in Japan).

### Examples

Preparation of epsilon crystal form copper phthalocyanine
1) Crystal phase conversion of copper phthalocyanine from beta crystal form to alpha crystal form
   80 parts by weight of the crude beta copper phthalocyanine is added to 800 parts by weight of 95 wt.% sulfuric acid. Further, the resultant mixture is stirred for 3 hours to prepare a suspension or solution of sulfate in the sulfuric acid. The suspension or the solution is poured to two times 8L of water to obtain an alpha crystal form copper phthalocyanine, which is then dried under hot air. After pulverizing the resulted solid, the alpha crystal form copper phthalocyanine is obtained almost quantitatively in terms of crystallographic yield, which is confirmed by a XRD study.
2) Kneading of copper phthalocyanine particles for crystal phase conversion from alpha crystal form to epsilon crystal form and particle size reduction To a lab-scale kneader, 50 parts by weight of the obtained copper phthalocyanine particles exhibiting a α crystallographic form and 12 parts by weight of the epsilon-type copper phthalocyanine are added with 80 parts by weight of diethylene glycol and 400 parts by weight of sodium chloride. The mixture is kneaded for 2 hours at 120°C with rotation speed of 50 rpm (1^{st} stage), and then for 8 hours at 50°C with the identical rotation speed (2^{nd} stage). After kneading, the resultant particles are recovered by filtration and dried at a temperature of 80°C and at a pressure of 10⁴ Pa. Upon analyzing the particles with TEM, the obtained copper phthalocyanine particles have smaller primary particle size and better particle shape compared to those of commercially available copper phthalocyanine particles (purchased from Dainippon Ink & Chemicals Co. located in Japan).

## Claims

1. A process of preparing copper phthalocyanine particles exhibiting a ε crystallographic form, comprising a kneading step by kneading at at least two different temperatures copper phthalocyanine particles wherein more than 80 wt % of the particles exhibit an α crystallographic form, in presence of at least one liquid and of at least one inorganic salt.

2. The process of Claim 1, further comprising a recovery step by recovering the copper phthalocyanine particles by removing the liquid and the inorganic salt.

3. The process of Claim 1 or 2, wherein the kneading step is conducted at the first temperature and then at the second temperature, and wherein the first temperature is higher than or equal to 80 °C and lower than or equal to 150 °C, preferably higher than or equal to 100 °C and lower than or equal to 120 °C, and the second temperature is higher than or equal to 30 °C and lower than or equal to 70 °C, preferably higher than or equal to 50 °C and lower than or equal to 60 °C.

4. The process of Claim 1 or 2, wherein the kneading step is conducted under a constantly varying temperature profile.

5. The process of any one of Claims 1 to 4, wherein the copper phthalocyanine particles exhibiting an α crystallographic form are prepared from copper phthalocyanine particles exhibiting a (β crystallographic form by using an acid paste method.

6. The process of any one of Claims 1 to 5, wherein the liquid is at least one liquid selected from the group consisting of water, N-methyl-2-pyrrolidone, sulfolane, N,N-dimethyl formamide, diethylene glycol, N-methyl formamide, diacetone alcohol, glycerin, ethylene glycol, propylene glycol, polypropylene glycol, 2-butoxy ethanol, triethylene glycol, diethylene glycol monomethyl ether, triethylene glycol monomethyl ether, dipropylene glycol monomethyl ether, 1-methoxy-2-propanol,1-ethoxy-2-propanol, ketones and quinolines.

7. The process of any one of Claims 1 to 6, wherein the liquid further comprises at least one acid selected from inorganic and organic acids.

8. The process of Claim 7, wherein the acid comprises sulfuric acid.

9. The process of any one of Claims 1 to 8, wherein the inorganic salt is at least one salt selected from the group consisting of aluminum sulfate, sodium sulfate, calcium chloride, potassium chloride and sodium chloride.

10. The process of any one of Claims 1 to 9, wherein particles of copper phthalocyanine substituted by at least one functional group selected from the group consisting of -SO₃M, -SO₂NR₁R₂ and -R₃-NR₄R₅,
wherein R₁ and R₂ are independent of one another and are hydrogen, alkyl, alkenyl, aryl or cycloalkyl; M is proton, ammonium cation or metal cation; R₃ is a single bond, alkylene, arylene, said alkylene and arylene may be substituted by at least one substituent; and R₄ and R₅ are independent of one another and are hydrogen, alkyl, alkenyl, aryl or cycloalkyl, or collectively form a condensed structure containing at least one of -CO-, -SO₂- and -N-N-,
are further added during the acid paste step or the kneading step.

11. The process of any one of Claims 2 to 9, further comprising a step of dry-blending wherein particles of copper phthalocyanine substituted by at least one functional group selected from the group consisting of -SO₃M, -SO₂NR₁R₂ and -R₃-NR₄R₅,
wherein R₁ and R₂ are independent of one another and are hydrogen, alkyl, alkenyl, aryl or cycloalkyl; M is proton, ammonium cation or metal cation; R₃ is a single bond, alkylene, arylene, said alkylene and arylene may be substituted by at least one substituent; and R₄ and R₅ are independent of one another and are hydrogen, alkyl, alkenyl, aryl or cycloalkyl, or collectively form a condensed structure containing at least one of -CO-, -SO₂- and -N-N-,
are further added to the phthalocyanine particles recovered after the recovery step.

12. The process of Claim 10 or 11, wherein the functional group is -SO₃H, -SO₂NHR, or 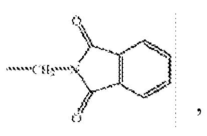 wherein R₁ is hydrogen, alkyl, alkenyl, aryl or cycloalkyl.

13. Copper phthalocyanine particles obtainable according to the process of any one of Claims 1 to 12.

14. Copper phthalocyanine particles according to claim 13 having an averaged particle size lower than or equal to 30 nm, as measured by a transmission electron microscope.

15. Color filter pigments comprising the copper phthalocyanine particles according to Claim 13 or 14.

16. Use of the copper phthalocyanine particles according to Claim 13 or 14 in the preparation of color filter pigments.

17. Use of the color filter pigments according to Claim 15 in the fabrication of liquid crystal display devices.
